# EUROPÄISCHE PATENTSCHRIFT

(11) **EP 1 948 386 B1**
(45) Veröffentlichungstag und Bekanntmachung des Hinweises auf die Patenterteilung: **26.03.2014**
(21) Anmeldenummer: 06828526.1
(22) Anmeldetag: 17.11.2006
(51) Int. Cl.: B23K 1/00, B23K 1/005, H01L 23/00

(54) **VERFAHREN ZUR HERSTELLUNG EINER KONTAKTANORDNUNG ZWISCHEN EINEM MIKROELEKTRONISCHEN BAUELEMENT UND EINEM TRÄGERSUBSTRAT SOWIE EINE MIT DEM VERFAHREN HERGESTELLTE BAUTEILEINHEIT**
METHOD FOR PRODUCING A CONTACT ARRANGEMENT BETWEEN A MICROELECTRONIC COMPONENT AND A SUPPORTING SUBSTRATE AS WELL AS COMPONENT UNIT PRODUCED BY SAID METHOD
PROCEDE POUR REALISER UN SYSTEME DE CONTACT ENTRE UN COMPOSANT MICRO-ELECTRONIQUE ET UN SUBSTRAT SUPPORT ET ASSEMBLAGE REALISE AU MOYEN DUDIT PROCEDE

(30) Priorität: 18.11.2005 DE 102005055505
(43) Veröffentlichungstag der Anmeldung: 30.07.2008
(73) Patentinhaber: Pac Tech - Packaging Technologies GmbH, 14641 Nauen (DE)
(72) Erfinder: AZDASHT, Ghassem, 13591 Berlin (DE)
(74) Vertreter: Böck, Bernhard
(86) Internationale Anmeldenummer: PCT/DE2006/002021
(87) Internationale Veröffentlichungsnummer: WO 2007/056997

(56) Entgegenhaltungen:
- DE-A1- 19 901 623
- US-A- 5 828 031
- US-A1- 2002 113 115
- US-A1- 2005 035 184

## Beschreibung

Die Erfindung betriff ein Verfahren zur Herstellung einer Kontaktanordnung zwischen einem mikroelektronischen Bauelement und einem Trägersubstrat sowie eine mit dem Verfahren hergestellte Bauteileinheit, wobei eine in Verbindungsbereichen notwendige Wärmeenergie durch rückwärtige Beaufschlagung des Bauelements mit Laserenergie erzielt wird, ein mechanischer Verbindungslcontakt zwischen einander gegenüberliegenden Verbindungsflächen des Bauelements und des Trägersubstrats ausgebildet wird, und zumindest ein elektrisch leitender Verbindungskontakt zwischen Anschlussflächen des Trägersubstrats und des Bauelements durch zumindest partielles Aufschmelzen von Lotmaterial ausgebildet wird.

Verfahren der eingangs genannten Art werden vorzugsweise zum Kontaktieren von mikroelektronischen Bauelementen, Sensoren, Aktuatoren oder MEMS-Bauelementen eingesetzt. Bei diesen im Allgemeinen als "Diebonden" bezeichneten Verfahren wird ein Bauelement auf einem Trägersubstrat mechanisch befestigt und über eine Draht- oder Lotverbindung mit Leiterbahnen des Trägersubstrats verbunden. Zur Ausbildung einer derartigen Verbindung in einem Arbeitsgang ist es bisher notwendig, eine Unterseite des Bauteils mit Anschlussflächen relativ zu gegenüberliegenden Anschlussflächen eines Trägersubstrats zu positionieren, so dass ein Kontaktspalt zwischen den Anschlussflächen ausgebildet wird, über den durch Aufschmelzen von Lotmaterial eine elektrische Verbindung hergestellt werden kann. Da das Bauelement nicht unmittelbar mit dem Trägersubstrat zur Anlage gelangt, sondern lediglich über die Kontaktflächen mit dem Trägersubstrat kontaktiert ist, ist es zur Herstellung einer innigen mechanischen Verbindung zwischen Bauelement und Trägersubstrat notwendig, ein Verbindungsmaterial, wie z.B. Klebermaterial, zur Ausfüllung eines zwischen Bauelement und Trägersubstrat gebildeten Hohlraums vorzusehen. Die Bauhöhe des Bauelements auf dem Trägersubstrat ist aufgrund der zwischenliegenden Anschlussflächen relativ hoch, wobei auch eine entsprechend große Menge Klebermaterial zur Ausbildung der mechanischen Verbindung über den Hohlraum hinweg verwendet werden muss. Nach der Kontaktierung des Bauelements ist eine visuelle Qualitätskontrolle der Lotverbindungen nicht möglich, da diese im Kontaktspalt der Anschlussflächen ausgebildet sind und vom Bauelement bzw. von Klebermaterial verdeckt werden.

Die DE 199 01 623 A1 zeigt ein Verfahren und eine Vorrichtung zur Ausbildung einer derartigen, zuvor beschriebenen Kontaktverbindung. Bei diesem Verfahren wird ein Bauelement von einer Kontaktiereinrichtung aufgenommen, rückwärtig mit Laserenergie zur Erzielung einer notwendigen Arbeitstemperatur beaufschlagt und mit einem Trägersubstrat kontaktiert. Das Bauelement wird vermittels Vakuum von der Kontaktiereinrichtung aufgenommen und gehalten. Die zur Erzielung der Arbeitstemperatur notwendige Laserenergie wird über eine Glasfaser in das Bauelement eingeleitet. So können gegenüberliegende Anschlussflächen des Trägersubstrats und des Bauelements durch Aufschmelzen von Lotmaterial kontaktiert, eine relativ große Menge Klebermaterial zur Ausbildung eines mechanischen Verbindungskontakts verdrängt und das Bauelement umgebend ausgehärtet werden.

Aus der US-A-5 828 031 ist ein Verfahren zur Herstellung einer Kontaktanordnung bekannt, bei dem ein Bauelement auf einem Trägersubstrat kontaktiert wird, wobei die Anschlussfläche des Bauelements und die Anschlussfläche des Trägersubstrats unter einem Winkel zueinander angeordnet sind. Zur Herstellung eines Lotmaterialkontakts zwischen der Anschlussfläche des Bauelements und der Anschlussfläche des Trägersubstrats wird ein Lotmaterialdepot mit einem Positionierungswerkzeug so gegen die beweglich zueinander angeordneten Anschlussflächen positioniert, dass das Lotmaterialdepot gleichzeitig gegen beide Anschlussflächen anliegt.

Der vorliegenden Erfindung liegt daher die Aufgabe zugrunde, ein Verfahren zur Herstellung einer Kontaktanordnung vorzuschlagen, das eine schnelle, einfache und kostengünstige Herstellung ermöglicht, und bei dem bzw, der ein Bauelement eine geringe Bauhöhe gegenüber einem Trägersubstrat sowie sichtbare, elektrisch leitende Verbindungskontakte aufweist.

Diese Aufgabe wird durch ein Verfahren mit den Merkmalen des Anspruchs 1 gelöst.

Bei dem erfindungsgemäßen Verfahren zur Herstellung einer Kontaktanordnung zwischen einem mikroelektronischen Bauelement und einem Trägersubstrat wird eine in Verbindungsbereichen notwendige Wärmeenergie durch rückwärtige Beaufschlagung des Bauelements mit Laserenergie erzielt. Hierdurch wird eine Aufheizung des Bauelements besonders einfach möglich, und aufgrund der kurzen Aufheizzeit wird eine unzuträgliche Temperaturbelastung für das Bauelement und das Trägersubstrat vermieden. Weiter wird ein mechanischer Verbindungskontakt zwischen einander gegenüberliegenden Verbindungsflächen des Bauelements und des Trägersubstrats ausgebildet und zumindest ein elektrisch leitender Verbindungskontakt zwischen Anschlussflächen des Trägersubstrats und des Bauelements durch zumindest partielles Aufschmelzen von Lotmaterial ausgebildet, wobei die Anschlussflächen unter einem Winkel zueinander angeordnet sind. Der zwischen den Anschlussflächen gebildete Winkel beträgt vorzugsweise 90°, kann aber auch 45°, 80°, 100°, 135° oder andere für eine derartige Verbindung geeignete Winkel größer 0° und kleiner 180° aufweisen. Da die Anschlussflächen nicht unmittelbar einander gegenüberliegend angeordnet sind, ergibt sich eine geringe Bauhöhe für das Bauelement auf dem Trägersubstrat, und der elektrisch leitende Verbindungskontakt ist sichtbar und kann einer optischen Qualitätskontrolle unterzogen werden. Weiter sind die Verbindungskontakte besonders einfach mit den bekannten Kontaktiereinrichtungen, welche das Bauelement vermittels Vakuum aufnehmen und rückwärtig mit Laserenergie beaufschlagen, ausbildbar.

In einer Ausführungsform kann vor Ausbildung der Kontaktanordnung ein Lotmaterialformstück an der Anschlussfläche des Bauelements angeordnet werden. So kann auf die Zuführung von Lotmaterial während des Verbindungsvorgangs durch eine Zuführvorrichtung verzichtet werden.

Als besonders vorteilhaft erweist es sich, wenn das Lotmaterialformstück mechanisch deformiert wird. So kann eine Benetzung der Anschlussfläche des Trägersubstrats mit Lot erfolgen, bevor die Verbindungsflächen des Bauelements und des Trägersubstrats zur gegenseitigen Anlage gelangen. Wenn das Lotmaterialformstück aufgrund der mechanischen Deformation das Bauteil über seine Verbindungsfläche hinaus überragt, ist besonders einfach eine sichere Ausbildung eines elektrischen Verbindungskontakts möglich.

Wird der mechanische Verbindungskontakt und der elektrisch leitende Verbindungskontakt in einem Arbeitsschritt ausgebildet, ist nur eine einmalige Beaufschlagung des Bauelements und des Trägersubstrats mit Wärmeenergie notwendig. Das Verfahren kann somit besonders schnell ausgeführt werden.

Als besonders vorteilhaft erweist es sich, wenn das Bauelement und das Trägersubstrat in einem Winkel relativ zueinander angeordnet werden, derart, dass in einem Scheitelpunkt eine Anschlussfläche mit einem Lotmaterialformstück bzw. Lotmaterialformstücke auf jeweils einer Anschlussfläche kontaktiert werden, und in einem zweiten Arbeitsschritt, durch Verschwenken des Bauelements um den Scheitelpunkt, die Verbindungsflächen kontaktiert werden. Durch die Benetzung einer Anschlussfläche mit Lot eines Lotmaterialformstücks bzw. durch die Verbindung zweier aufgeschmolzener Lotmaterialformstücke kann zunächst der elektrisch leitende Verbindungskontakt sicher ausgebildet werden, bevor nachfolgend die Verbindungsflächen kontaktiert werden.

Wird der mechanische Verbindungskontakt vermittels Verbindungsmaterial ausgebildet, welches am Bauelement oder am Trägersubstrat aufgebracht wird, kann eine relativ feste mechanische Verbindung ausgebildet werden. Die Verwendung von geringen Mengen Verbindungsmaterial zur Ausbildung eines Verbindungskontakts ist ausreichend, da mit dem Verbindungsmaterial kein Hohlraum überbrückt werden muss.

In einer Ausführungsform kann als Verbindungsmaterial Klebermaterial verwendet werden. Das Klebermaterial kann auf dem Trägersubstrat oder auf der Verbindungsfläche des Bauelements einfach aufgebracht werden. Das Klebermaterial kann ein thermoplastisches Polymer oder ein durch Temperatur oder Kombination aus Temperatur und UV-Bestrahlung aushärtendes Klebermaterial sein. Es kann auch als Folie oder durch Dispensieren sowie andere Methoden der Filmauftragung aufgebracht werden.

In einer weiteren Ausführungsform kann als Verbindungsmaterial Lotmaterial verwendet werden. So kann der mechanische Verbindungskontakt mit dem gleichen Verbindungsmaterial ausgebildet werden wie der elektrisch leitende Verbindungskontakt. Die Anzahl der dem Verfahren vorgelagerten Arbeitsschritte kann weiter reduziert werden, wenn das Trägersubstrat und das Bauelement ausschließlich mit Lotmaterial verbindbar sind und auf die Verwendung von Klebermaterial verzichtet werden kann.

Nachfolgend wird eine bevorzugte Ausführungsform der Erfindung unter Bezugnahme auf die beigefügte Zeichnung näher erläutert.

Es zeigen:
- **Fig. 1**: ein Bauelement und ein Trägersubstrat vor einer Kontaktierung in einer Seitenansicht;
- **Fig. 2**: das Bauelement und das Trägersubstrat mit einer Kontaktiereinrichtung in einer ersten Ausführungsform des Verfahrens;
- **Fig. 3**: das Bauelement und das Trägersubstrat mit der Kontaktiereinrichtung in einer zweiten Ausführungsform des Verfahrens;
- **Fig. 4**: das Bauelement und das Trägersubstrat nach Ausbildung einer Kontaktanordnung;
- **Fig. 5**: das Bauelement und das Trägersubstrat mit der Kontaktiereinrichtung in einer dritten Ausführungsform des Verfahrens;
- **Fig. 6**: das Bauelement und das Trägersubstrat mit der Kontaktiereinrichtung in einer vierten Ausführungsform des Verfahrens;
- **Fig. 7**: das Bauelement und das Trägersubstrat mit der Kontaktiereinrichtung in der vierten Ausführungsform des Verfahrens während eines ersten Arbeitsschritts;
- **Fig. 8**: das Bauelement und das Trägersubstrat mit einer Kontaktiereinrichtung in einem Beispiel eines Kontaktierungsverfahrens;
- **Fig. 9**: das Bauelement und das Trägersubstrat mit einer Kontaktiereinrichtung in einem Beispiel eines Kontaktierungsverfahrens.

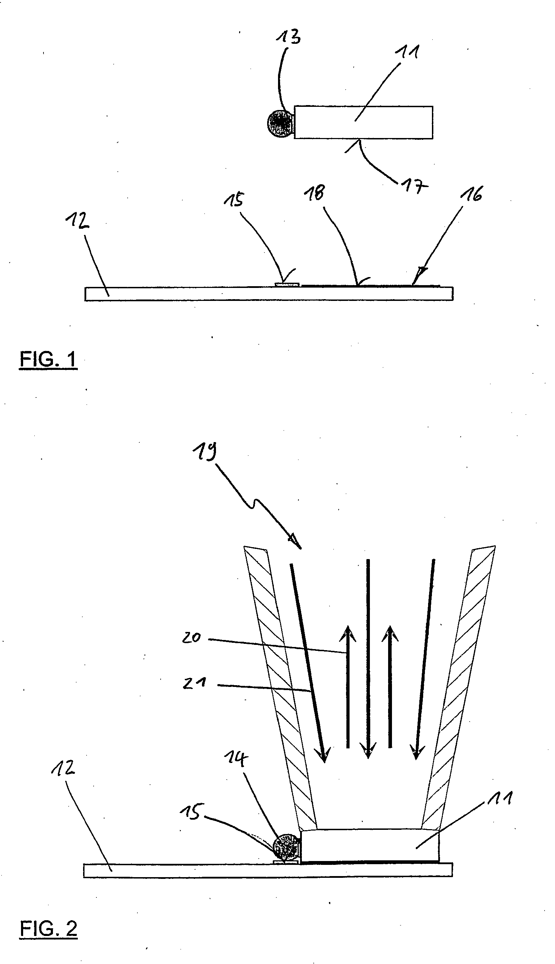

Eine Zusammenschau aus **Fig. 1, Fig. 2** und **Fig. 4** zeigt eine Abfolge von Arbeitsschritten zur Ausbildung einer Kontaktanordnung 10 zwischen einem mikroelektronischen Bauelement 11 und einem Trägersubstrat 12. **Fig. 1** zeigt die Anordnung des Bauelements 11 zum Trägersubstrat 12 unmittelbar vor Ausbildung einer Kontaktanordnung 10. An einer Anschlussfläche 13 des Bauelements 11 ist ein als Lotkugel 14 ausgebildetes Lotmaterialformstück an die Anschlussfläche 13 kontaktiert. Das Trägersubstrat 12 verfügt über eine Anschlussfläche 15 und eine Kleberschicht 16, welche zur Ausbildung eines mechanischen Verbindungskontakts zwischen dem Bauelement 11 und dem Trägersubstrat 12 dient. Die Anschlussfläche 13 ist in einem Winkel relativ zur Anschlussfläche 15 angeordnet, wobei eine Verbindungsfläche 17 des Bauelements 11 parallel gegenüberliegend einer Verbindungsfläche 18 des Trägersubstrats 12 angeordnet ist.

Das Bauelement 11 wird, wie in Fig. 2 gezeigt, von einer hier schematisch dargestellten Kontaktiereinrichtung 19 vermittels Vakuum, welches durch die Pfeile 20 veranschaulicht ist, an der Kontaktiereinrichtung 19 zur Handhabung fixiert. Weiter wird das Bauelement 11 rückwärtig mit Laserenergie beaufschlagt, die hier vereinfacht durch die Pfeile 21 dargestellt ist.

Bei der in der **Fig. 2** gezeigten Kontaktierung der Verbindungsflächen 17, 18 und der Lotkugel 14 mit der Anschlussfläche 15 erfolgt eine Erwärmung des Bauelements 11 und des Trägersubstrats 12, derart, dass es zu einer teilweisen Aufschmelzung der Lotkugel 14 und zu einer Benetzung der Anschlussfläche 15 mit Lot zur Ausbildung eines elektrisch leitenden Verbindungskontakts 22 kommt. Gleichzeitig wird durch Erwärmung der Kleberschicht 16 ein mechanischer Verbindungskontakt 23 zwischen Bauelement 11 und Trägersubstrat 12 ausgebildet.

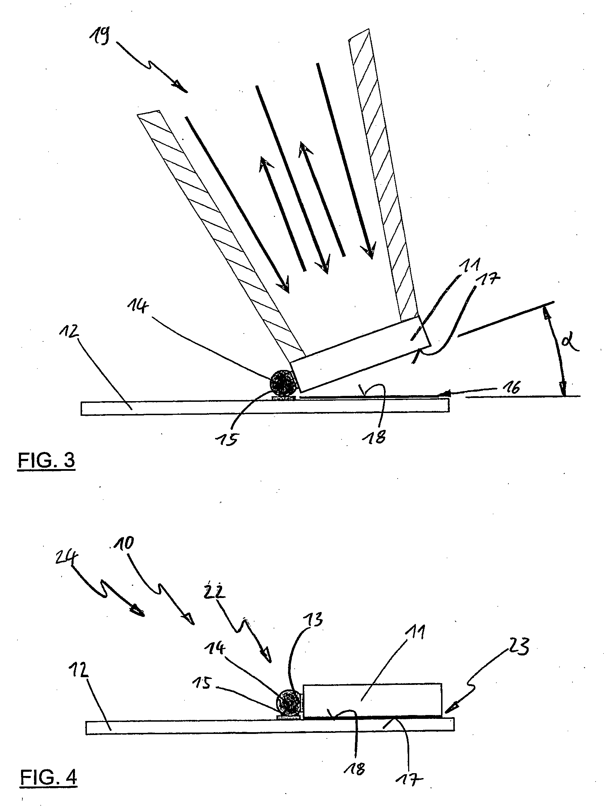

Die abschließend durch Aushärten der Kleberschicht 16 und Erstarrung der aufgeschmolzenen Lotkugel 14 ausgebildete Bauteileinheit 24 in der Kontaktanordnung 10 zeigt **Fig. 4**.

Eine zweite Ausführungsform des Verfahrens zeigt **Fig. 3**. Hier erfolgt zunächst eine Kontaktierung der Lotkugel 14 mit der Anschlussfläche 15 des Trägersubstrats 12. Dazu wird das Bauelement 11 um einen Winkel α relativ zum Trägersubstrat 12 verschwenkt. Nachdem die Lotkugel 14 aufgeschmolzen ist und die Anschlussfläche 15 benetzt hat, wird das Bauelement 11 um den Winkel α in eine parallele Lage zum Trägersubstrat 12 verschwenkt, so dass die Verbindungsflächen 17 und 18 mit der zwischenliegenden Kleberschicht 16 zur Anlage gelangen. Nach Aushärtung der Kleberschicht 16 und Erstarrung der Lotkugel 14 ist die in **Fig. 4** gezeigte Bauteileinheit 24 ausgebildet.

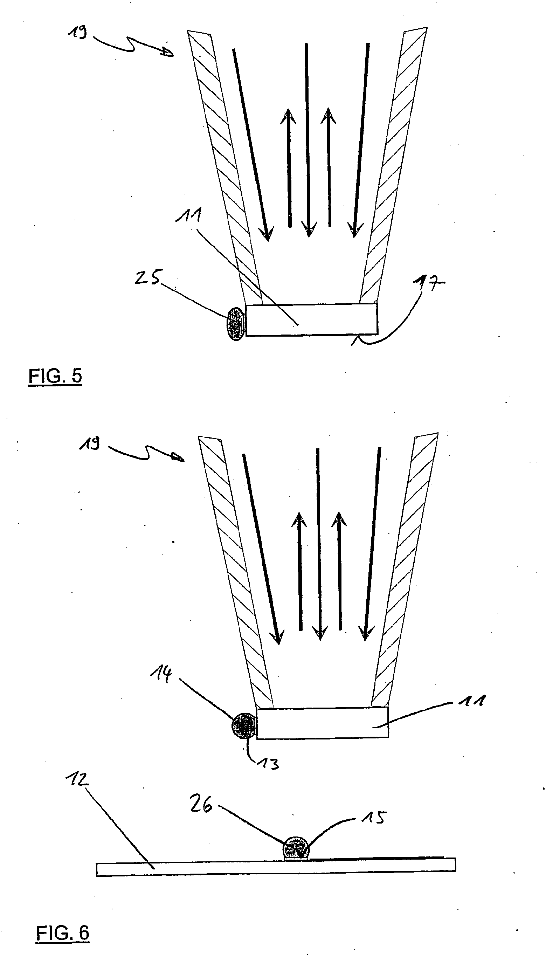

**Fig. 5** zeigt eine dritte Ausführungsform des Verfahrens, in der eine Lotkugel 25 für eine gute Verbindung mit einem Trägersubstrat vor Verbindung mit dem Trägersubstrat mechanisch deformiert wird und die in **Fig. 5** gezeigte, annähernd elliptische geometrische Struktur hat. Die Lotkugel 25 überragt die Verbindungsfläche 17 des Bauelements 11, so dass vor Kontaktierung der Verbindungsfläche 17 mit einer gegenüberliegenden Verbindungsfläche eine Kontaktierung der Lotkugel 25 mit einer gegenüberliegenden Anschlussfläche erfolgt. Nach dem Aufschmelzen der Lotkugel 25 wird die Lotkugel 25 durch die Oberflächenspannung wieder in eine kugelartige Form gebracht.

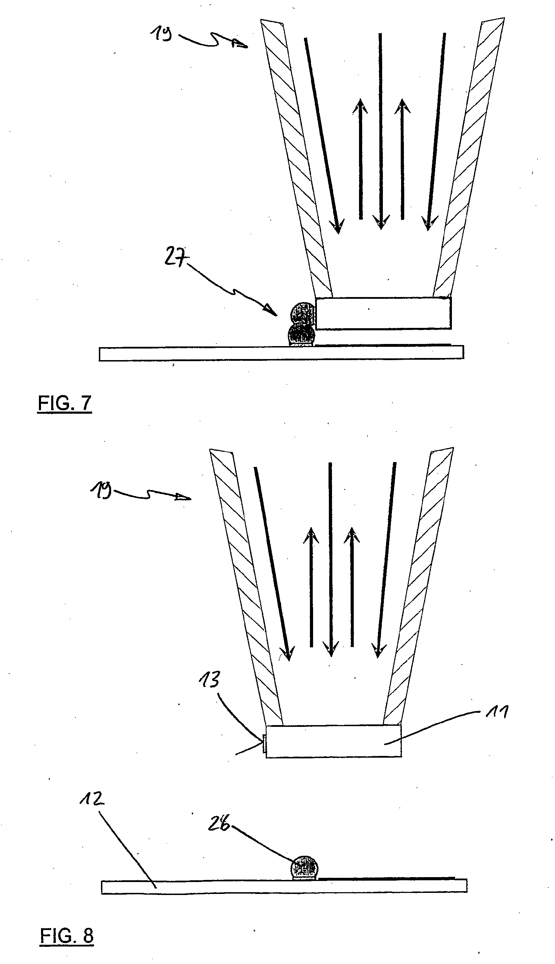

**Fig. 6** zeigt eine vierte Ausführungsform des Verfahrens, bei der die Anschlussfläche 13 des Bauelements 11 mit der Lotkugel 14 und die Anschlussfläche 15 des Trägersubstrats 12 mit einer Lotkugel 26 versehen ist. Wie **Fig. 7** weiter zeigt, erfolgt bei einer Annäherung des Bauelements 11 zum Trägersubstrat 12 eine Kontaktierung beider Lotkugeln 14 und 26, wobei vor Ausbildung eines mechanischen Verbindungskontaktes beide Lotkugeln 14, 26 zu einer Lotverbindung 27 aufschmelzen. Die Lotverbindung 27 kann eine hier nicht gezeigte, größere Lotkugel als elektrischen Verbindungskontakt ausbilden.

**Fig. 8** zeigt ein Beipiel eines Verfahrens das nicht der vorliegenden Erfindung entspricht, bei dem die Lotkugel 26 auf der Anschlussfläche 15 des Trägersubstrats 12 angeordnet ist und das Bauelement 11 mit der Anschlussfläche 13 der Lotkugel 26 zur Kontaktierung zugeführt wird.

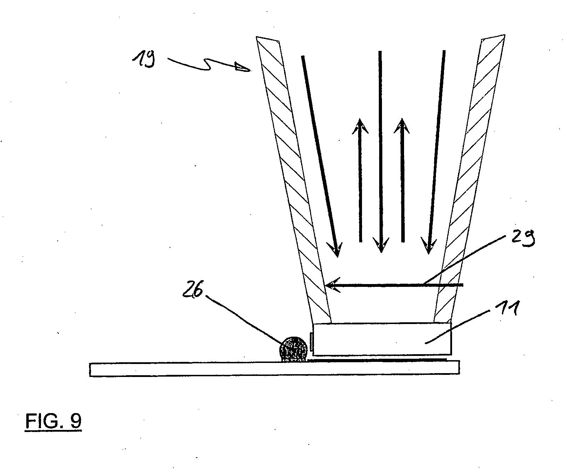

**Fig. 9** zeigt ein Beispiel eines Verfahrens das nicht der vorliegenden Erfindung entspricht, bei dem zur guten Ausbildung einer Verbindung das Bauelement 11 während der Kontaktierung in Richtung der Lotkugel 26, wie mit dem Pfeil 29 angedeutet, bewegt wird. Die Bewegung des Bauelements 11 kann in eine Richtung oszillierend sein.

## Patentansprüche

1. Verfahren zur Herstellung einer Kontaktanordnung (10) zwischen einem mikroelektronischen Bauelement (11) und einem Trägersubstrat (12), wobei eine in Verbindungsbereichen notwendige Wärmeenergie durch rückwärtige Beaufschlagung des Bauelements mit Laserenergie erzielt wird, ein mechanischer Verbindungskontakt (23) zwischen einander gegenüberliegenden Verbindungsflächen (17, 18) des Bauelements und des Trägersubstrats ausgebildet wird, und zumindest ein elektrisch leitender Verbindungskontakt (22) zwischen Anschlussflächen (13, 15) des Trägersubstrats und des Bauelements durch zumindest partielles Aufschmelzen von Lotmaterial ausgebildet wird,
**dadurch gekennzeichnet,**
**dass** die Anschlussflächen unter einem Winkel zueinander angeordnet sind, und vor Ausbildung der Kontaktanordnung (10) ein Lotmaterialformstück (14, 25) an der Anschlussfläche (13) des Bauelements (11) angeordnet wird und zusammen mit dem Bauelement zur nachfolgenden Kontaktierung auf dem Trägersubstrat angeordnet wird.

2. Verfahren nach Anspruch 1,
**dadurch gekennzeichnet,**
**dass** das Lotmaterialformstück (25) vor Ausbildung der Kontaktanordnung (10) mechanisch deformiert wird.

3. Verfahren nach Anspruch 1 oder 2,
**dadurch gekennzeichnet,**
**dass** der mechanische Verbindungskontakt (23) und der elektrisch leitende Verbindungskontakt (22) in einem Arbeitsschritt ausgebildet werden.

4. Verfahren nach einem der vorangehenden Ansprüche 1 bis 3,
**dadurch gekennzeichnet,**
**dass** das Bauelement (11) und das Trägersubstrat (12) in einem Winkel (α) relativ zueinander angeordnet werden, derart, dass in einem Scheitelpunkt eine Anschlussfläche (15) mit einem Lotmaterialformstück (14, 25) beziehungsweise Lotmaterialformstücke (14, 25, 26) auf jeweils einer Anschlussfläche (13, 15) kontaktiert werden und in einem zweiten Arbeitsschritt, durch Verschwenken des Bauelements um den Scheitelpunkt, die Verbindungsflächen (17, 18) kontaktiert werden.

5. Verfahren nach einem der vorangehenden Ansprüche,
**dadurch gekennzeichnet,**
**dass** der mechanische Verbindungskontakt (23) vermittels Verbindungsmaterial ausgebildet wird, welches am Bauelement (11) oder am Trägersubstrat (12) aufgebracht wird.

6. Verfahren nach Anspruch 5,
**dadurch gekennzeichnet,**
**dass** als Verbindungsmaterial Klebermaterial (16) verwendet wird.

7. Verfahren nach Anspruch 5,
**dadurch gekennzeichnet,**
**dass** als Verbindungsmaterial Lotmaterial verwendet wird.

## Claims

1. A method for producing a contact arrangement (10) between a microelectronic component (11) and a carrier substrate (12), wherein a thermal energy that is required in connecting areas is achieved by exposing the back of the component to laser energy, a mechanical connecting contact (23) is formed between opposing connecting surfaces (17, 18) of the component and the carrier substrate, and at least one electrically conducting connecting contact (22) is formed between terminal faces (13, 15) of the carrier substrate and of the component by at least partial melting of solder material,
**characterised in that**
the terminal faces are arranged at an angle to one another, and, before the contact arrangement (10) is formed, a moulded piece of solder material (14, 25) is arranged on the terminal face (13) of the component (11) and together with the component is arranged on the carrier substrate for subsequent contacting.

2. The method according to Claim 1,
**characterised in that**
the moulded piece of solder material (25) is mechanically deformed prior to forming the contact arrangement (10).

3. The method according to claim 1 or 2,
**characterised in that**
the mechanical connecting contact (23) and the electrically conducting connecting contact (22) are formed in one step.

4. The method according to any one of the preceding Claims 1 through 3,
**characterised in that**
the component (11) and the carrier substrate (12) are arranged at an angle (α) relative to one another in such a way that at a crown point a terminal face (15) is contacted with a moulded piece of solder material (14, 25) and/or multiple moulded pieces of solder material (14, 25, 26) are contacted on a terminal face (13, 15) each, and in a second step the connecting surfaces (17, 18) are contacted by swivelling the component around the crown point.

5. The method according to any one of the preceding claims,
**characterised in that**
the mechanical connecting contact (23) is formed by means of connecting material, which is applied to the component (11) or to the carrier substrate (12).

6. The method according to Claim 5,
**characterised in that**
adhesive material (16) is used as the connecting material.

7. The method according to Claim 5,
**characterised in that**
solder material is used as the connecting material.

## Revendications

1. Procédé pour réaliser un arrangement de contact (10) entre un composant micro-électronique (11) et un substrat de support (12), dans lequel une énergie calorifique étant nécessaire dans des régions de liaison est atteinte en soumettant le composant à de l'énergie de laser par l'arrière, un contact mécanique de liaison (23) est formé entre des surfaces de liaison (17, 18) opposées du composant et du substrat de support, et au moins un contact de liaison (22) électroconducteur est formé entre des surfaces de raccordement (13, 15) du substrat de support et du composant par une fusion au moins partielle de matériau de soudage,
**caractérisé en ce que**
les surfaces de raccordement sont arrangées l'une par rapport à l'autre en formant un angle et, avant la formation de l'arrangement de contact (10), une pièce moulée (14, 25) en matériau de soudage est disposée sur la surface de raccordement (13) du composant (11) et est disposée avec le composant sur le substrat de support pour la mise en contact suivante.

2. Procédé selon la revendication 1,
**caractérisé en ce que**
la pièce moulée (25) en matériau de soudage est déformée mécaniquement avant la formation de l'arrangement de contact (10).

3. Procédé selon la revendication 1 ou 2,
**caractérisé en ce que**
le contact de liaison (23) mécanique et le contact de liaison (22) électroconducteur sont formés dans une étape de procédé.

4. Procédé selon l'une quelconque des revendications précédentes 1 à 3,
**caractérisé en ce que**
le composant (11) et le substrat de support (12) sont disposés l'un par rapport à l'autre en formant un angle (α) de telle manière que, dans un sommet, une surface de raccordement (15) soit contactée avec une pièce moulée (14, 25) en matériau de soudage et/ou des pièces moulées (14, 25, 26) en matériau de soudage soient contactées respectivement sur une surface de raccordement (13, 15) et, dans une deuxième étape de procédé, les surfaces de liaison (17, 18) soient contactées par un pivotement du composant autour du sommet.

5. Procédé selon l'une quelconque des revendications précédentes,
**caractérisé en ce que**
le contact de liaison (23) mécanique est formé au moyen de matériau de liaison qui est appliqué sur le composant (11) ou sur le substrat de support (12).

6. Procédé selon la revendication 5,
**caractérisé en ce que**
du matériau adhésif (16) est utilisé comme matériau de liaison.

7. Procédé selon la revendication 5,
**caractérisé en ce que**
du matériau de soudage est utilisé comme matériau de liaison.
